# EUROPEAN PATENT APPLICATION

(11) **EP 4 679 959 A1**
(43) Date of publication of application: **14.01.2026**
(21) Application number: 25188606.5
(22) Date of filing: 09.07.2025
(51) Int. Cl.: H05K 7/20

(54) **DYNAMIC UNIT STAGING METHOD FOR COOLING SYSTEM**

(30) Priority: 10.07.2024 US 202463669612 P
(71) Applicant: Vertiv Corporation, Westerville, OH 43082 (US)
(72) Inventor: TAKACS, Balint, Westerville, 43082 (US); BARBATO, Pierpaolo, Westerville, 43082 (US); VOIGT, Tyler William, Westerville, 43082 (US)
(74) Representative: Beal, James Michael

(57) **Abstract**

A system and method for dynamic unit staging of a group of cooling delivery units mathematically models cooling capacity and energy consumption for each individual unit and for the group as a whole. Unit and group cooling capacity and energy consumption models are stored to memory accessible to a supervisory system along with a control profile providing for unit activation thresholds and allowable modification ranges for said thresholds. During each online operating cycle, the supervisory system determines the required cooling capacity (based on ambient air temperature) to maintain a data center within a required temperature range. Based on the cooling capacity requirement and applicable group energy consumption models, the supervisory system identifies a set of optimal switching thresholds within predetermined threshold modification ranges for unit activation, via which the group of cooling delivery units can maintain the required cooling capacity while minimizing overall energy consumption.

## Description

### CROSS-REFERENCE TO RELATED APPLICATIONS

The present application claims the benefit of U.S. Provisional Patent Application Serial Number 63/669,612 filed July 10, 2024, titled DYNAMIC UNIT STAGING METHOD FOR COOLING SYSTEM.

### TECHNICAL FIELD

The present disclosure is directed to systems for providing thermal management within enclosed spaces where a controlled environment is required.

### BACKGROUND

Data centers house large amounts of servers and information technology (IT) devices in close proximity within an enclosed environment, which means the heat generated by these servers and devices must be removed from the enclosed environment to prevent their overheating. Cooling delivery units (e.g., cooling units, computer room air conditioner (CRAC) units) maintain the data center or enclosed climate-controlled environment at a temperature conducive to optimal server operations by absorbing heat from within the environment and transferring that heat away from the physical location of the servers. For example, cooling delivery units may be connected to a circulating fluid loop: air is chilled by cooler water or working fluid introduced into the environment (e.g., to a target supply-air temperature (SAT)), and the chilled air is directed into the environment at a particular flow rate. The circulating air absorbs heat before returning to the cooling delivery units (e.g., at a higher return air temperature (RAT)), wherein the heat is transferred from the return air to the working fluid. The warmer working fluid is then circulated away from the environment for re-chilling (and, e.g., removal of the transferred heat from the fluid).

Cooling delivery units often operate in groups, e.g., based on a group operation mode or policy that determines how many cooling delivery units are operating at any one time, e.g., based on the required cooling load as determined by ambient air temperatures (AAT) measured or sensed within the environment, e.g., if the AAT is trending away from the required temperature range, the required cooling load increases as more heat must be transferred and circulated away from the environment. However, the deployment of groups of cooling delivery units may not always be the most energy efficient means of maintaining target temperatures within the environment.

### SUMMARY

In a first aspect, a thermal management system for dynamic unit staging of a group of cooling delivery units (e.g., for maintaining a data center or like enclosed environment within a predetermined temperature range) is shown. In embodiments, the thermal management system includes a group of two or more cooling delivery units and a local unit controller for group management of the cooling delivery units. A supervisory system monitors conditions at or around the data center in order to continually determine an optimally energy efficient (e.g., minimizing energy consumption) of maintaining conditions within the data center as required via group deployment of the cooling delivery units. The supervisory system first determines, and stores to memory, a set of group cooling capacity models based on the cooling capacity of each individual cooling delivery unit and a control profile defining group management parameters. The supervisory system also determines one or more group energy consumption models for each group cooling capacity model based on the unit energy consumption model for each individual cooling delivery unit. Group cooling capacity and group energy consumption models may be derived based on a variety of conditions and/or sets of conditions, e.g., possible ambient air temperature (AAT) values sensed outside the data center; airflow within the data center; individual unit activations. Once these models are generated and stored, the supervisory system executes operation cycles (e.g., periodically, continually, as needed) to optimize energy consumption while maintaining temperature requirements within the data center. For example, the supervisory system senses the current AAT and discards any group cooling capacity or group energy consumption models not corresponding to that AAT. The supervisory system determines a current cooling capacity requirement for the data center (e.g., based on supply and return air temperatures) and, based on the capacity requirement, determines a set of optimal switching thresholds. Optimal switching thresholds may be used by the local area controller to manage the activation, deactivation, and/or ramping of individual cooling delivery units within the group (e.g., ramping a cooling delivery unit between zero cooling capacity, or an off/standby state, and full cooling capacity in concert with other devices of the group).

In some embodiments, control profiles for a group of cooling delivery units include unit activation thresholds determining when (and/or to what extent) each individual device of the group is activated, and a threshold modification range above and/or below each unit activation threshold. For example, each optimal switching threshold represents an activation, deactivation, or ramping of a particular cooling delivery unit at a point within its threshold modification range but that may not be equivalent to its activation threshold. In other words, the supervisory system may determine that a particular cooling delivery unit should be activated, deactivated or ramped sooner or later than would ordinarily be the case if doing so would minimize overall energy consumption.

In some embodiments, the group of cooling delivery units is a homogeneous group where all cooling delivery units are of a common type and accordingly share a unit cooling capacity model and a unit energy consumption model. Further, the control profile may include an ordered list of cooling delivery units, e.g., in order of activation.

In some embodiments, the group of cooling delivery units is a heterogeneous group including two or more different types of cooling delivery units, where each type of cooling delivery unit shares a unit cooling capacity model and a unit energy consumption model for that type. Further, the control profile may include an ordered list of cooling delivery units of the group, ordered by order of activation (e.g., by type, where all units of Type A are activated before any unit of Type B is activated, or by device).

In some embodiments, the group cooling capacity model for a group of cooling delivery units is a function of a subset of active cooling delivery units (e.g., based on which units of the group are activated and/or to what capacity).

In some embodiments, each group cooling capacity model corresponds to a specific AAT.

In some embodiments, a cooling capacity requirement for the data center is based on a required return air temperature (RAT) and/or supply air temperature (SAT).

In some embodiments, each control profile includes a group operating mode for management of the group of cooling delivery units (e.g., reach-and-keep mode, parallel mode).

In some embodiments, the supervisory system forwards the determined set of optimal switching thresholds to the local unit controller for implementation.

In some embodiments, operation cycles executed by the supervisory system, e.g., "online mode", are executed periodically, e.g., at a predetermined time interval. In some embodiments, operation cycles are executed in response to a triggering event or condition (e.g., change in AAT at or above a threshold level).

In a further aspect, a method for dynamic unit staging of a thermal management system including a group of cooling delivery units is disclosed. In embodiments, the method includes providing, for each of a group of cooling delivery units for maintaining a data center or like enclosed environment within a predetermined temperature range, a unit cooling capacity model and a unit energy consumption model. The method includes providing a control profile for group management of the cooling delivery units. The method includes providing a set of group cooling capacity models corresponding to the group of cooling delivery units, where each group cooling capacity model is based on the unit cooling capacity models for each cooling delivery unit as well as parameters defined by the group control profile. The method includes providing, for each group cooling capacity model, one or more group energy consumption models, wherein each group energy consumption model is based on the set of unit energy consumption models (e.g., in addition to other factors). The method includes executing one or more operation cycles (e.g., "online mode") via a supervisory system in communication with the local unit controller managing the group of chiller delivery units. For example, each operation cycle includes sensing or otherwise determining an ambient air temperature (AAT) outside the data center; determining a cooling capacity requirement for the data center, and (based, e.g., on the cooling capacity requirement and group energy consumption models corresponding to the current AAT) a set of optimal switching thresholds corresponding to a minimal energy consumption by the group of chiller delivery units while maintaining the data center within temperature requirements under the current conditions.

In some embodiments, each control profile includes one or more unit activation thresholds for each cooling delivery unit (e.g., determining when the unit is activated, deactivated, or ramped) and a threshold modification range extending above and/or below the unit activation threshold. For example, each optimal switching threshold is within the threshold modification range for the corresponding cooling delivery unit but may provide for activation, deactivation, and/or ramping of the cooling delivery unit sooner or later than would ordinarily be the case based on the unit activation threshold.

In some embodiments, the method includes providing a common unit cooling capacity model for each of a homogeneous group of cooling delivery units of a common type. Further, the method includes providing an ordered list of the cooling delivery units of the group in order of activation.

In some embodiments, the method provides, for each type of a heterogeneous group of cooling delivery units of two or more different types, a unit cooling capacity model and unit energy consumption model common to all cooling delivery units of that type. Further, the method includes providing an ordered list of the cooling delivery units of the group in order of activation.

In some embodiments, the ordered list is prioritized by type of unit (e.g., each unit of type A activated first, then each unit of type B, etc.)

In some embodiments, the method includes providing a group cooling capacity model based on a subset of active cooling delivery units of the group (e.g., based on how many units are currently active, and at what capacity).

In some embodiments, the method includes providing a set of group cooling capacity models where each group cooling capacity model corresponds to a specific AAT, e.g., with a range of possible AAT.

In some embodiments, the method includes determining a required return air temperature (RAT) and supply air temperature (SAT) and determining a cooling capacity requirement for the data center based on the required RAT and SAT.

In some embodiments, the method includes forwarding the set of optimal switching thresholds to the local unit controller for implementation.

In some embodiments, the method includes executing operation cycles on a periodic basis (e.g., every N minutes) or in response to a triggering event or condition (e.g., a change in AAT at or above a threshold level between regular operation cycles).

This Summary is provided solely as an introduction to subject matter that is fully described in the Detailed Description and Drawings. The Summary should not be considered to describe essential features nor be used to determine the scope of the Claims. Moreover, it is to be understood that both the foregoing Summary and the following Detailed Description are example and explanatory only and are not necessarily restrictive of the subject matter claimed.

### BRIEF DESCRIPTION OF THE DRAWINGS

The detailed description is described with reference to the accompanying figures. The use of the same reference numbers in different instances in the description and the figures may indicate similar or identical items. Various embodiments or examples ("examples") of the present disclosure are disclosed in the following detailed description and the accompanying drawings. The drawings are not necessarily to scale. In general, operations of disclosed processes may be performed in an arbitrary order, unless otherwise provided in the claims. In the drawings:
FIG. 1A is a block diagram of a climate-controlled data center environment incorporating group operation of cooling delivery units (CDU) for maintaining the data center environment within a required temperature range while minimizing total energy consumption by the group, according to example embodiments of the inventive concepts disclosed herein;
FIG. 1B is a diagrammatic illustration of homogeneous and heterogeneous CDU groups of the data center environment of FIG. 1A;
FIG. 1C is a block diagram of a supervisory system (e.g., supervisory controller) for the CDU groups of FIGS. 1A and 1B;
FIG. 2A is a graphical illustration of unit activation thresholds for a group of cooling delivery units;
FIG. 2B is a graphical illustration of unit activation thresholds and unit ramping profiles for a group of cooling delivery units operating under a reach-and-keep control profile;
FIG. 2C is a graphical illustration of unit activation thresholds and unit ramping profiles for a group of cooling delivery units operating under a parallel-use control profile;
FIG. 3 is a diagrammatic illustration of an offline operational flow for determining unit/group cooling capacity models and unit/group energy consumption models for the group of cooling delivery units of FIGS. 1A and 1B;
FIG. 4 is a diagrammatic illustration of an online operational flow for determining optimal switching thresholds for the group of cooling delivery units of FIGS. 1A and 1B, based on the group cooling capacity and energy consumption models of FIG. 3 and on current ambient air temperatures;
FIG. 5A is a graphical illustration of unit activation threshold modification ranges associated with dynamic unit staging of the group of cooling delivery units of FIGS. 1A and 1B;
FIG. 5B is a graphical illustration of an exemplary set of optimal switching thresholds selected to maintain temperature requirements while minimizing energy consumption by the group of cooling delivery units of FIGS. 1A and 1B;
FIG. 6A is a graphical illustration of group cooling capacity and group energy consumption by the group of cooling delivery units of FIGS. 1A and 1B in response to a system level call for cooling;
FIG. 6B is a graphical illustration of group cooling capacity and group energy consumption by the group of cooling delivery units of FIGS. 1A and 1B based on implementation of optimal switching thresholds as shown by FIG. 5B; and
FIGS. 7A and 7B are process flow diagrams illustrating a method for dynamic unit staging according to example embodiments of this disclosure.

### DETAILED DESCRIPTION

Before explaining one or more embodiments of the disclosure in detail, it is to be understood that the embodiments are not limited in their application to the details of construction and the arrangement of the components or steps or methodologies set forth in the following description or illustrated in the drawings. In the following detailed description of embodiments, numerous specific details may be set forth in order to provide a more thorough understanding of the disclosure. However, it will be apparent to one of ordinary skill in the art having the benefit of the instant disclosure that the embodiments disclosed herein may be practiced without some of these specific details. In other instances, well-known features may not be described in detail to avoid unnecessarily complicating the instant disclosure.

As used herein a letter following a reference numeral is intended to reference an embodiment of the feature or element that may be similar, but not necessarily identical, to a previously described element or feature bearing the same reference numeral (e.g., 1, 1a, 1b). Such shorthand notations are used for purposes of convenience only and should not be construed to limit the disclosure in any way unless expressly stated to the contrary.

Further, unless expressly stated to the contrary, "or" refers to an inclusive or and not to an exclusive or. For example, a condition A or B is satisfied by any one of the following: A is true (or present) and B is false (or not present), A is false (or not present) and B is true (or present), and both A and B are true (or present).

In addition, use of "a" or "an" may be employed to describe elements and components of embodiments disclosed herein. This is done merely for convenience and "a" and "an" are intended to include "one" or "at least one," and the singular also includes the plural unless it is obvious that it is meant otherwise.

Finally, as used herein any reference to "one embodiment" or "some embodiments" means that a particular element, feature, structure, or characteristic described in connection with the embodiment is included in at least one embodiment disclosed herein. The appearances of the phrase "in some embodiments" in various places in the specification are not necessarily all referring to the same embodiment, and embodiments may include one or more of the features expressly described or inherently present herein, or any combination or sub-combination of two or more such features, along with any other features which may not necessarily be expressly described or inherently present in the instant disclosure.

Broadly speaking, embodiments of the inventive concepts disclosed herein are directed to systems and methods for optimizing unit staging of a group of cooling delivery units in order to maintain environmental temperature requirements while minimizing total energy consumption by the cooling delivery units.

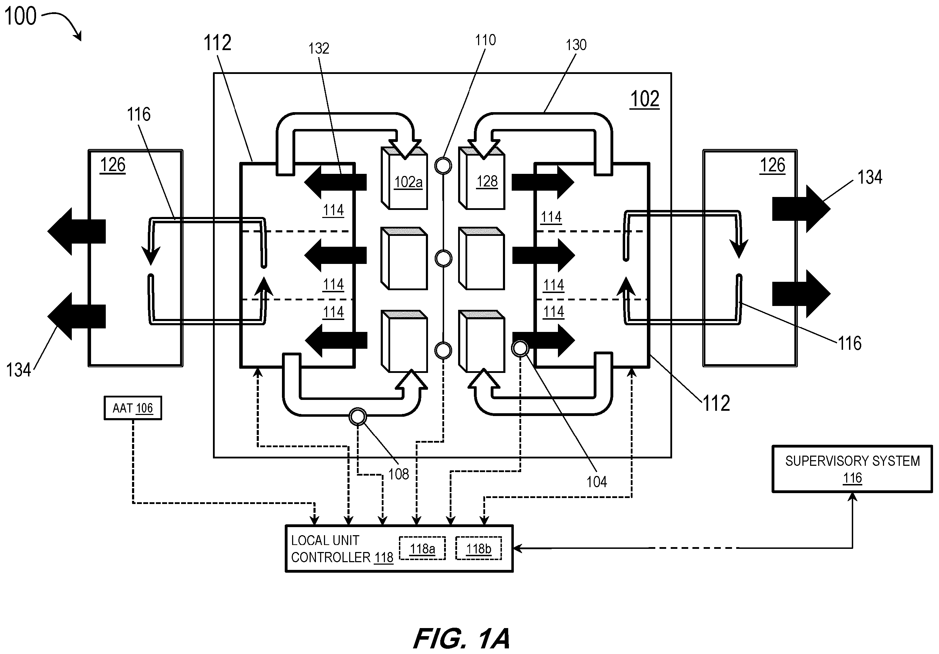

Referring to FIG. 1A, a data center environment 100 is shown. The data center environment 100 may include: a data center 102, which includes return air temperature (RAT) sensors 104 and supply air temperature (SAT) sensors 106; remote temperature (REM) sensors 110; a system or group 112 of cooling delivery units 114 (CDUs) and one or more fluid networks 116 (e.g., fluid loops), which system or group may further include a local unit controller 118; and a supervisory system 120 which includes at least one optimization processor 122 and a memory 124 or like data storage. External to, or outside, the data center 102 may be disposed ambient air temperature (AAT) sensors 106 and chiller devices 126 capable of dissipating heat absorbed by the CDUs 114 into the outside air. In some embodiments, the CDUs 114 and chiller devices 126 (or functionalities thereof) may be combined within a single apparatus or system having components both internal and external to the data center 102.

In embodiments, the data center 102 may include any enclosed space to be maintained within a predetermined required temperature range, e.g., per a service level agreement (SLA). For example, the data center 102 may house servers, switches, and/or other sensitive information technology (IT) devices 128 (e.g., any other appropriate sensitive heat-generating devices) capable of generating heat based on their operating power. Further, if heat generated by IT devices 128 within the data center 102 is not transferred from within the enclosed space, rising temperatures may frustrate or inhibit device operations (e.g., requiring unplanned downtime). Accordingly, the CDUs 114 and chiller devices 126 may maintain the data center 102 within the required temperature range on a continual and uninterrupted basis to preserve seamless operation of any IT devices 128 operating therein.

In embodiments, the group 112 of CDUs 114 may include multiple cooling delivery units operating collectively to absorb heat generated by IT devices 128 within the data center 102 and transfer that heat outside the data center, e.g., into the ambient air external to the data center or to the chiller devices 126 for dissipation to the outside air. For example, the CDUs 114 may provide a chilled air supply 130 into the data center 102 and accept warmer return air 132 that has circulated through, and absorbed heat from within, the data center 102. Further, the CDUs 114 may circulate the warmer return air 132 to be re-cooled by the fluid network 116, passing the transferred heat to the chiller devices 126, which in turn remove the transferred heat (134) to the outside air.

In embodiments, the CDUs 114 and chiller devices 126 may be connected via one or more fluid networks 116. For example, each CDU 114 may include air supply vents or ducts for introducing the chilled air supply 130 into the data center 102 (and, e.g., directing said chilled air supply toward one or more servers 102a) and air returns for accepting warmer return air 132 from within the data center. In embodiments, excess heat may be transferred from within the data center 102 to the warmer return air 132 and from the return air to the fluid network 116, thus re-cooling the chilled air supply 130 for recirculation into the data center 102. For example, the fluid network 116 may pass transferred heat to the chiller devices 126, where the heat is expelled into the ambient air, and the fluid network 116 likewise re-cooled for recirculation to the CDUs 114.

In embodiments, temperature data relevant to the data center environment 100 and/or data center 102 may be provided by RAT sensors 104, AAT sensors 106, SAT sensors 108, and/or REM sensors 110. For example, RAT sensors 104 may measure temperatures of return air 132 returning to the CDUs 114 for re-cooling. Similarly, SAT sensors 108 may measure temperatures of the chilled air supply 130 provided to the data center 102 via the CDUs 114. REM sensors 110 may measure air temperatures within the data center 102 proximate to the servers 102a, while AAT sensors 106 may measure ambient air temperatures outside the data center 102. In embodiments, one or more of these sources of temperature data may be used by the supervisory system 120 to determine a required cooling capacity.

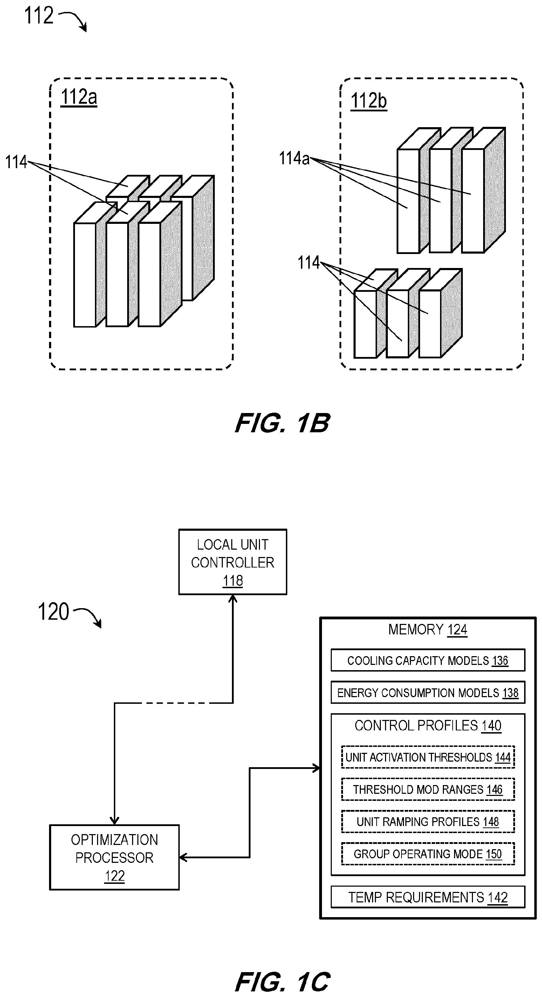

In embodiments, referring also to FIG. 1B, a group 112 of multiple CDUs 114 may operate collectively to maintain the data center 102 within the required temperature range. For example, the group 112 may be a homogeneous group 112a of homogeneous CDUs 114, e.g., wherein all CDUs are substantially identical with respect to their type, performance (e.g., unit cooling capacity), and energy consumption. In some embodiments, the data center 102 may instead include a heterogeneous group 112b of heterogeneous CDUs 114, 114a. For example, the heterogeneous group 112b may include a set of CDUs 114 sharing common cooling capacity and energy consumption specifications and a set of dissimilar CDUs 114a sharing among each other a different set of cooling capacity and energy consumption specifications, the two sets of CDUs 114, 114a operating together as a single group. Further, the heterogeneous group 112b may in some cases include three, four, or more types of CDUs 114, 114a likewise operating as a single group.

In embodiments, group operations for homogeneous and heterogeneous CDU groups 112a, 112b may be managed by the local unit controller 118. For example, the local unit controller 118 may include one or more control processors 118a programmed, e.g., via encoded instructions provided by a user and stored in memory 118b, to manage the operation of each individual CDU 114, 114a (e.g., "unit staging"). Unit staging may include the activation, deactivation, and/or ramping of individual CDUs 114, 114a (e.g., "ramping" referring to a gradual increase or decrease of one or more parameters of an individual CDU, such as a supply temperature of the chilled air supply 130 or a fan speed) such that individual CDUs do not compete with each other, and further that changes in the amount of heat generated within the data center 102 are addressed by the CDUs as a group 112. In embodiments, as will be discussed further below, the local unit controller 118 may control unit staging of the CDU groups 112, 112a, 112b according to a particular unit staging or operating mode (unit staging scheme, unit staging strategy).

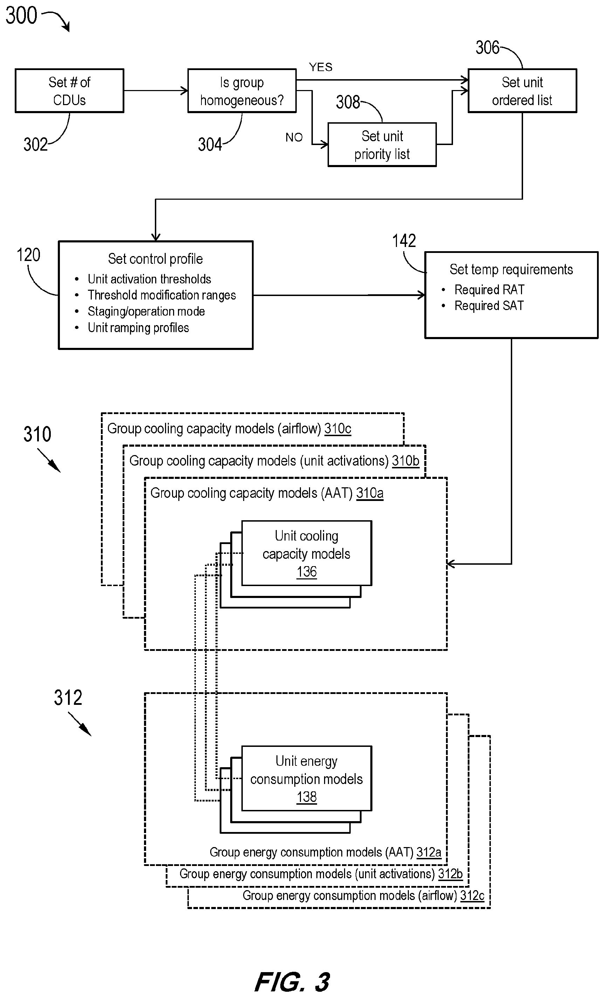

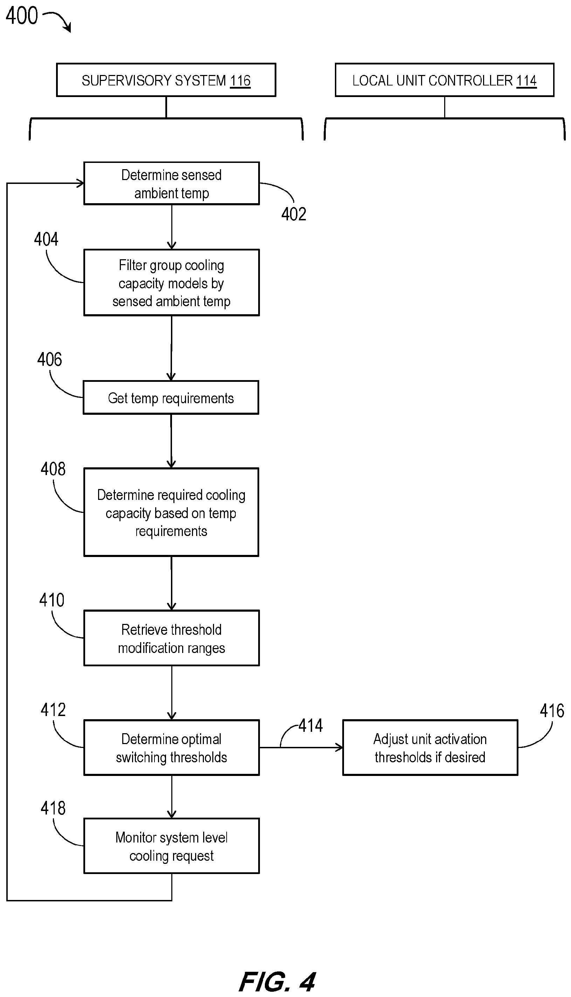

In embodiments, referring also to FIG. 1C, the supervisory system 120 may include one or more optimization processors 122 and memory 124. For example, the optimization processor 122 may perform offline and/or online evaluation (as shown by, e.g., FIGS. 3 and 4) of dynamic unit staging for the CDU groups 112, 112a, 112b. In embodiments, the memory 124 may provide data storage for mathematical models for unit cooling capacity 136 (e.g., unit performance) and energy consumption 138 for each CDU 114 or for each CDU type 114, 114a of a homogeneous or heterogeneous group 112a, 112b. Further, the memory 124 may provide data storage for control profiles 140 regulating group operation (e.g., activation, deactivation, ramping) of the chiller devices 126 as well as any temperature requirements 142 relevant to the temperature conditions to be maintained on a constant basis within the data center 102. For example, control profiles 140 may include, for each CDU 114, 114a, a set of unit activation thresholds 144, a threshold modification range 146 for one or more unit activation thresholds, and a unit ramping profile 148. Further, control profiles 140 may include, for each CDU group 112, 112a, 112b as a whole, a group operating mode 150 (e.g., reach-and-keep, parallel) regulating group staging of the component CDUs 114, 114a of the group. In embodiments, temperature requirements 142 may specify a required return air temperature (RAT) and/or a required supply air temperature (SAT).

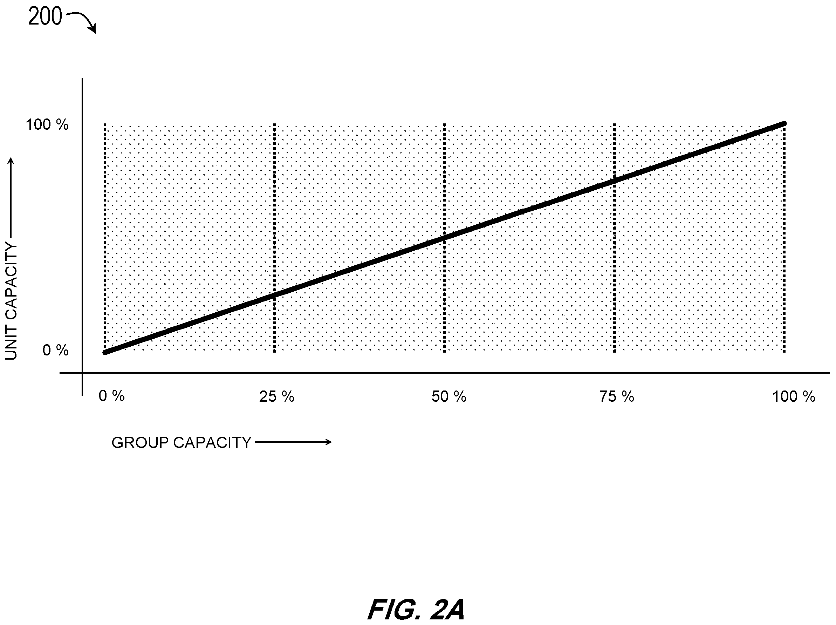

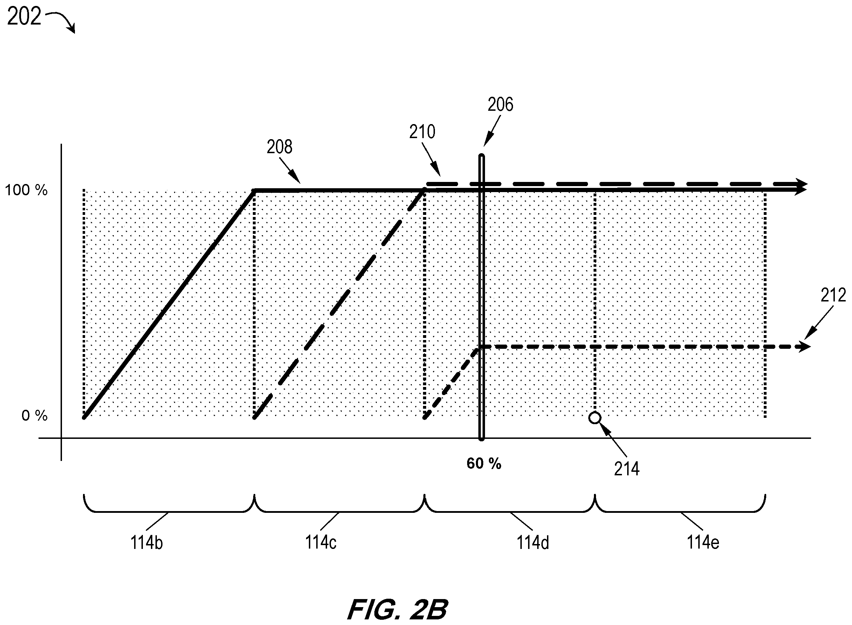

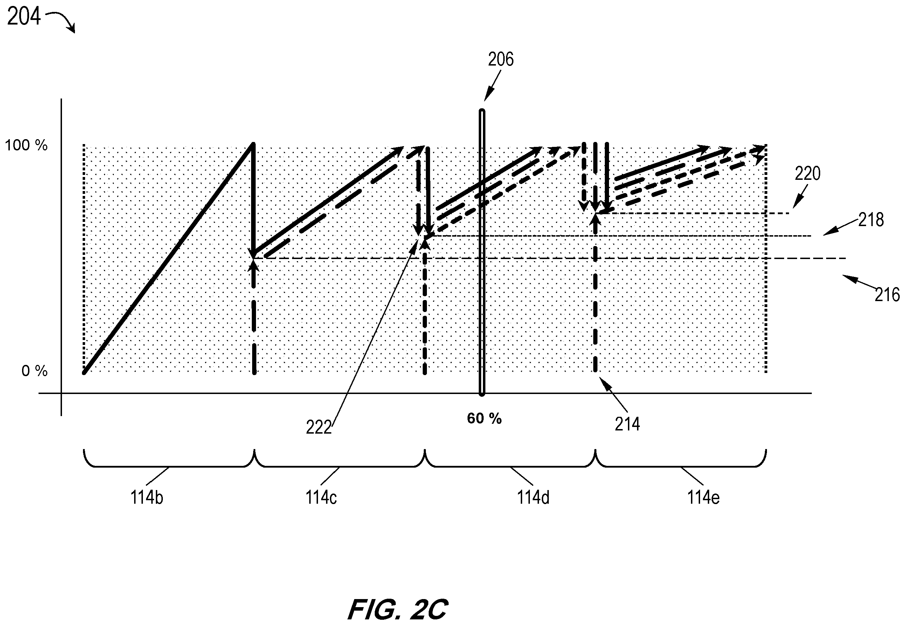

Referring to FIGS. 2A through 2C, in embodiments group operations of the groups 112, 112a, 112b of CDUs 114, 114a may be managed by the local unit controller 118 according to a reach-and-keep staging mode (e.g., group operating mode 150), as shown by FIG. 2B, or according to a parallel staging mode, as shown by FIG. 2C. For example, staging modes as described below may apply to either homogeneous or heterogeneous CDU groups 112a, 112b.

Referring in particular to FIG. 2A, the graph 200 may represent unit activation thresholds 144 for the group 112, 112a, 112b of individual CDUs 114, 114a as a function of a system-level call for cooling (e.g., within the group). For example, given the group 112a of N homogeneous CDUs 114 (e.g., where N is an integer), unit activation thresholds 144 (e.g., switching thresholds) may be set at each 1/N of full group cooling capacity (x-axis; e.g., for a group of four homogeneous CDUs 114b, 114c, 114d, 114e at 0, 25, 50, 75, and 100 percent of full group cooling capacity). Further, while unit activation thresholds 144 for the homogeneous group 112a as a whole may be identical (as shown by the graphs 202, 204 of FIGS. 2B and 2C) whether the group is operating in reach-and-keep or in parallel staging mode, the staging modes 150 may differ according to unit ramping profiles 148, e.g., in how one or more already active CDUs 114b-114e (e.g., each unit operating somewhere between 0% and 100% of the unit's full capacity) react to the activation of a previously inactive CDUs (e.g., wherein the status of an individual CDUs changes from OFF or STANDBY to ON).

Referring in particular to FIG. 2B, the graph 202 represents the behavior of each individual CDU 114b-114e of the homogeneous group 112a (operating in reach-and-keep mode) in response to a system-level call for cooling to the group. For example, in response to a system-level call for 0 to 25% of the group cooling capacity, the first CDU 114b may be ramped from 0% to 100% of its unit cooling capacity (e.g., y-axis). In embodiments, when the system-level call for cooling is between two unit activation thresholds 144, any already active CDUs 114b-114e operating according to the nearest unit activation threshold under the system-level call may continue to operate at 100% of unit cooling capacity while an additional CDU serves as a control mechanism whereby the unit cooling capacity of the additional CDU may be ramped up or down to address heat load fluctuation. For example, when the system level call 206 for cooling is at 60% of group cooling capacity, the CDUs 114b, 114c may each run at 100% of unit cooling capacities 208 and 210, respectively, the CDU 114d may run at partial cooling capacity (212; e.g., about one-third of unit cooling capacity), and the CDU 114e may remain inactive (214).

In embodiments, referring in particular to FIG. 2C, the graph 204 represents the behavior of each individual CDU 114b-114e of the homogeneous group 112a (operating in parallel staging mode) in response to the system-level call 206 for cooling to the group. For example, when the homogeneous group 112a operates in parallel mode, the local unit controller 118 may direct all active CDUs 114b-114e in a parallel ramping scheme to mitigate heat load fluctuations in response to the system-level call.

In embodiments, in response to the system-level call 206 for 60% of group cooling capacity, three individual CDUs 114b-114d may operate at partial unit capacity while the fourth CDU 114e remains inactive. By way of a further example, unit activation thresholds 144 may be identical to those in reach-and-keep mode but may be handled differently: at 25% of group cooling capacity the CDU 114b operating at full unit capacity may be ramped down to 50% capacity (216) while the CDU 114c is activated and ramped to 50% capacity such that both CDUs 114b, 114c are ramped up in parallel to address system-level calls between 25% and 50% of group cooling capacity. Similarly, when additional CDUs 114d, 114e are activated and ramped up to partial cooling capacity (218), the already active CDUs 114b, 114c may be ramped down (220) to an equivalent unit cooling capacity and all active CDUs gradually ramped up until the next unit activation threshold 144 is reached.

In embodiments, embodiments of the inventive concepts disclosed herein are directed to dynamic unit staging operations for the homogeneous or heterogeneous CDU groups 112a, 112b wherein the fixed unit activation thresholds 144 are replaced with floating activation thresholds (e.g., within the threshold activation ranges 146 for each threshold) whereby the CDU groups 112, 112a, 112b maintain the data center 102 within the required temperature ranges (as heat loads fluctuate) while minimizing the total energy consumption of any active CDUs 114, 114a-114e at any given time.

In embodiments, a dynamic unit staging method for the homogeneous or heterogeneous CDU groups 112a, 112b deployed to the data center 102 may include three general components: mathematical modeling of each CDU (e.g., with respect to individual unit cooling capacity and unit energy consumption); selection of a group control profile (including, e.g., reach-and-keep, parallel, or any other appropriate unit staging mode/s/ governing activations, deactivations, and ramping of CDUs; unit activation thresholds 144; threshold modification intervals or ranges 146 within which each unit activation threshold may float; unit ramping profiles 148); and determination of optimal switching thresholds, e.g., a set of unit activation thresholds within their respective threshold modification intervals, chosen so that the group maintains cooling load requirements while overall energy consumption is minimized). With respect to the homogeneous CDU group 112a, mathematical modeling may be relatively straightforward as unit cooling capacity and unit energy consumption are consistent among all CDUs. However, with respect to the heterogeneous group 112b of CDUs 114, 114a, mathematical modeling may further include the determination of a priority order (e.g., queue) for the activation of each CDU within the group (e.g., all CDUs 114 of a first type may be activated prior to the activation of any CDUs 114a of a second type).

In embodiments, mathematical modeling of the CDUs 114, 114a may be based on white-box, grey-box, or black-box models, or any combination thereof. For example, modeling data may include laboratory measurements, rating software, and/or field observations. Further, black-box and grey-box models may incorporate any combination of linear/polynomial regression, neural networks of any appropriate type, decision trees and/or forests, and support vector machine (SVM) machine learning.

In embodiments, referring now to FIG. 3, the evaluation of optimal dynamic unit activation thresholds (e.g., switching thresholds) may include both offline and online components. For example, the offline component 300 (e.g., offline precalculation) may include the precalculation (e.g., via the optimization processor 122 of the supervisory system 120, as shown by FIG. 1C) of mathematical models for cooling capacity and energy consumption for each individual CDU 114, 114a and for each homogeneous or heterogeneous group 112, 112a, 112b as a whole based on a variety of factors. In embodiments, precalculation inputs may include: determining the number (302) of CDUs 114, 114a within the respective group 112, 112a, 112b; determining whether (304) the CDU group 112 is a homogeneous group 112a of same-type CDUs 114 or a heterogeneous group 112b of dissimilar-type CDUs 114, 114a; an ordered list 306 determining the order in which CDUs 114, 114a are activated or ramped, which may further include a priority list 308 determining the activation or ramping order of different types of CDUs (e.g., for heterogeneous CDU groups 112b); a control profile 140 (e.g., unit ramping profiles 148 and unit activation thresholds 144 for each CDU; threshold modification ranges 146 for one or more unit activation thresholds 144; group staging/operating mode 150 (reach-and-keep, parallel, etc.)); and required temperature data 142 corresponding to the required temperature range at which the data center 102 is to be maintained, for example, required SAT and RAT as measurable by the SAT and RAT sensors 104, 108 shown by FIG. 1A.

In embodiments, based on the control profile 140 and temperature requirements 142, the optimization processor 122 may determine unit cooling capacity models 136 for each CDU 114 of the homogeneous CDU group 112a (or for each CDU 114, 114a of the heterogeneous CDU group 112b). For example, the homogeneous CDU group 112a may share a common unit cooling capacity model 136 among all component CDUs 114. Similarly, each type of CDU 114, 114a of the heterogeneous CDU group 112b may share a common unit cooling capacity model 136, such that a heterogeneous CDU group including M total CDUs 114, 114a of N types (e.g., wherein M, N are integers; first CDU type 114, second CDU type 114a) may include N different unit cooling capacity models.

In embodiments, the optimization processor 122 may precalculate a group cooling capacity model 310 for the homogeneous or heterogeneous CDU group 112a, 112b based on the unit cooling capacity models 136 generated for each component CDU 114, 114a. For example, group cooling capacity models 310 may further account for the number 302 of CDUs 114, 114a in a heterogeneous CDU group 112b. For example, a group having P CDUs 114 of a first type and Q CDUs 114a of a second type, where P ≠ Q, may be modeled differently than a group cooling capacity model for a group having Q CDUs 114 of the first type and P CDUs 114a of the second type.

In embodiments, group cooling capacity models 310 may be precalculated (and presented, e.g., in tabular form) by the optimization processor 122 as, for example: a function 310a of ambient air temperature (AAT), e.g., for a range of possible ambient air temperatures reportable by the AAT sensor (106, FIG. 1A); a function 310b of unit activations, e.g., based on the unit ramping profiles 148 and unit activation thresholds 144 provided by the control profile 140; and/or as a function 310c of airflow into the data center 102, e.g., as a response to increased heat loads. For example, the optimization processor 122 may calculate a unit cooling capacity model 136, and therefore a group cooling capacity model 310, corresponding to each AAT within a predetermined range of possible AAT, e.g., in increments of 0.1° C.

In embodiments, the optimization processor 122 may precalculate group energy consumption models 312 for the homogeneous or heterogeneous CDU group 112a, 112b based on each group cooling capacity model 310, as well as the individual unit energy consumption models 138 for each component CDU 114, 114a. For example, a group energy consumption model 312 corresponding to a given group cooling capacity model 310 may incorporate a unit energy consumption model 138 based on the unit cooling capacity model 136 for each CDU 114, 114a, and adjusted, e.g., based on unit activation thresholds 144, unit ramping profiles 148, temperature requirements 142, a given AAT, and/or other factors. Similarly, to the group cooling capacity models 310, the group energy consumption models 312 may likewise be precalculated and/or presented, e.g., as a function 312a of AAT; as a function 312b of unit activations; or as a function 312c of airflow. In embodiments, precalculated group cooling capacity models 310 and group energy consumption models 312 may be stored to the memory 124 of the supervisory system 120 for use in online evaluation of optimized dynamic unit staging as described below.

In embodiments, referring now to FIG. 4, online evaluation 400 of dynamic unit staging by the supervisory system 120 may determine optimal switching points for the homogeneous or heterogeneous group 112a, 112b of CDUs 114, 114a for maintaining a given cooling capacity associated with constant maintenance of the data center 102 within a required temperature range while minimizing overall energy consumption by the CDU group 112 on a continual basis. For example, online evaluation 400 may occur on a periodic basis (e.g., every five minutes) and/or on a conditional basis, e.g., triggered by one or more events. In embodiments, trigger events may include, but are not limited to: a change in AAT at or above a threshold level (e.g., 3%) or a change in airflow (indicative of a higher or lower heat load).

In embodiments, the supervisory system 120 may first determine (402) a current AAT within the data center 102, e.g., as measured by the AAT sensor 106.

In embodiments, based on the current AAT, the supervisory system 120 may filter (404) the precalculated performance and energy consumption solutions (310/312, FIG. 3) such that only precalculated solutions associated with the current AAT (or the closest available AAT, if there is no precise match for the sensed AAT) are considered.

In embodiments, the supervisory system 120 may determine (406) temperature requirements 142, e.g., a required SAT and/or RAT for maintaining the data center 102 within the required temperature range.

In embodiments, the supervisory system 120 may determine (408) current cooling capacity requirements (cooling load requirements) based on the determined temperature requirements.

In embodiments, the supervisory system 120 may determine, based on the cooling capacity requirements, a set of optimal switching thresholds configured for maintenance of the required cooling load by the group 112 of CDUs 114 while minimizing energy consumption by the group of cooling delivery units.

For example, the supervisory system 120 may refer (410) to the active control profile 140 stored to memory 124 to determine threshold modification ranges 146 for each CDU 114 stored in the memory to determine the maximum allowed deviation from stored unit activation thresholds 144.

Further, the supervisory system 120 may determine and return (412) a set of optimal switching thresholds (optimal switching points), based on, e.g., precalculated group cooling capacity models 310 applying to the current AAT and determined cooling capacity, as well as the group energy consumption models 312 corresponding to each applicable group cooling capacity model. For example, the set of optimal switching thresholds may include, for each group 112 of cooling delivery units 114, an optimal switching threshold within each threshold modification range 146 associated with a particular CDU of the group. In particular, each optimal switching threshold may represent a point where a particular CDU 114 of the group 112 is activated, deactivated, or ramped up or down (e.g., the percentage of full unit cooling capacity at which the CDU is currently operated is adjusted upward or downward).

In embodiments, the set of optimal switching thresholds may be chosen by the supervisory system 120 such that the required cooling capacity to be provided by the group 112 of CDUs 114 is maintained while the minimum possible energy consumption by the CDU group is achieved. For example, given the filtered set of group cooling capacity models 310 applicable to the current AAT, further filtered to the set of group cooling capacity models capable of achieving at least the required cooling capacity, the set of group energy consumption models 312 corresponding to each remaining group cooling capacity model may be compared until a group energy consumption model corresponding to a specific set of unit activation thresholds 144 is found. The specific group energy consumption model 312 may be such that no other corresponding set of unit activation thresholds 144 achieves a lower total energy consumption (e.g., based on the unit energy consumption models 138 for each CDU 114). In embodiments, the set of optimal switching thresholds may correspond to the current set of unit activation thresholds 144; alternatively, one or more optimal switching thresholds may float, or deviate in one direction or the other within their threshold modification ranges 146.

In embodiments, the supervisory system 120 may forward (414) the set of optimal switching thresholds to the local unit controller (118, FIG. 1A) for the CDU group 112, which may adjust (416) the unit activation thresholds 144 for one or more component CDUs 114 according to the set of optimal switching thresholds. For example, if an adjustment to one or more unit activation thresholds 144 would result in a reduction in overall energy consumption, the local unit controller 118 may implement one or more of the set of optimal switching thresholds. Further, the supervisory system 120 may, on a dynamic basis, monitor (418) system-level calls 206 or request for cooling and/or other events that may trigger a subsequent cycle of online evaluation 400 (e.g., if periodic cycles of online evaluation are not scheduled, or the system-level cooling request occurs between two regularly scheduled periodic cycles).

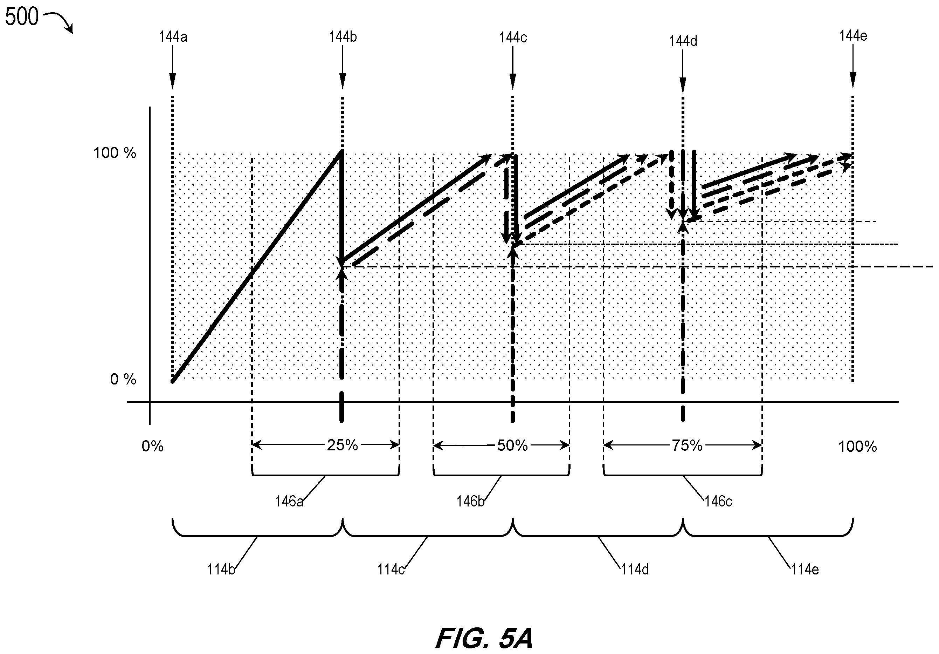

Referring now to FIG. 5A, the graph 500 shows examples of threshold modification ranges 146a-146c for the unit activation thresholds 144b-144d as determined by the supervisory system 120 as disclosed above. For example, assuming a homogeneous group 112a of four homogeneous cooling delivery units 114b-114e and a parallel staging mode according to the control profile 140 (e.g., as shown above by the graph 204 of FIG. 2C), the threshold modification ranges 146a-146c may represent allowable deviations from the unit activation thresholds 144b-144d with respect to activation and ramping of individual CDUs. In embodiments, the ordered activation list 306 provided by the control profile 140 may provide for activation of CDUs 114b-114e within the homogeneous group 112a in the following order: a first CDU 114b to be activated (e.g., at unit activation threshold 144a, 0% of group cooling capacity); a second CDU 114c (e.g., at unit activation threshold 144b, 25% of group cooling capacity); a third CDU 114d (e.g., at unit activation threshold 144c, 50% of group cooling capacity); and a fourth and final CDU 114e (e.g., at unit activation threshold 144d, 75% of group cooling capacity). Further, at each unit activation threshold 144a-144d, any already active CDUs 114b-114e may be ramped up or down with respect to their current operating percentage relative to full unit cooling capacity (as discussed above and shown by FIG. 2C) according to the current staging/operating mode 150 and/or the unit ramping profiles 148 provided by the control profile 140.

In embodiments, the allowable threshold modification range 146a relative to the 25% activation threshold 144b (e.g., for the CDU 114c) as shown by the graph 500 may extend roughly between 12% and 32% of group cooling capacity). Similarly, the allowable threshold modification range 146b relative to the 50% unit activation threshold 144c (e.g., for the CDU 114d) may extend roughly between 37% and 59% of group cooling capacity, and the allowable threshold modification range 146c relative to the 75% unit activation threshold 144d (e.g., for the CDU 114e) may extend roughly between 65% and 86% of group cooling capacity. In some embodiments, the unit activation thresholds 144a, 144e corresponding respectively to zero (0%) and full (100%) group cooling capacity (the unit activation threshold 144a corresponding to activation of the first CDU 114b), may not have associated threshold modification ranges.

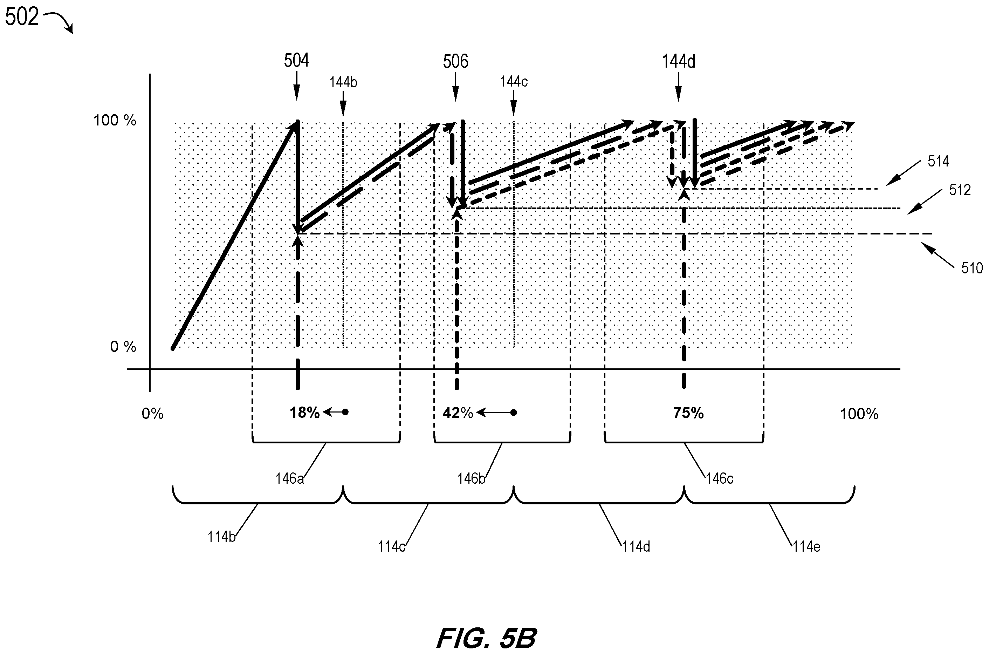

In embodiments, referring also to FIG. 5B, the graph 502 shows an exemplary set of optimal switching thresholds 504 and 506 selected by the supervisory system 120. For example, each optimal switching threshold 504, 506 may represent a unit activation threshold 144b, 144c, 144d floating within its respective threshold modification range 146a, 146b, 146c, the precise optimal switching thresholds selected in order to maintain the required cooling load while minimizing energy consumption by active CDUs 114b-114e (e.g., as opposed to operations of the CDUs according to other unit activation thresholds). With respect to the graph 502, for example, dynamic movement of a unit activation threshold 144a, 144b to the left may represent an earlier activation of a corresponding CDU 114c, 114d, e.g., in response to a system-wide call for cooling 206 at a lower proportion of group cooling capacity. For example, the first CDU 114b may reach full cooling capacity, and the second CDU 114c may be activated (e.g., at partial cooling capacity 510) at 18% of group cooling capacity (e.g., optimal switching threshold 504) rather than at 25% (at which time the first CDU 114b may be ramped down to the same level of partial cooling capacity, and the two CDUs 114b, 114c subsequently ramped up to full unit cooling capacity in unison). Similarly, the first and second CDUs 114b, 114c may reach full unit cooling capacity, and the third CDU 114d activated at partial cooling capacity 512, at 42% (e.g., optimal switching threshold 506) rather than at 50% of full group cooling capacity (at which time the first and second 114b, 114c may be ramped down to the same partial cooling capacity and the three active CDUs 114b-114d ramped back up to full unit cooling capacity in unison). In embodiments, some unit activation thresholds 144d (e.g., indicating when the fourth and last CDU 114e is to be activated at partial cooling capacity 514, and the CDUs 114b-114d ramped down thereto) may remain unchanged, e.g., if no energy may be conserved by allowing the unit activation threshold to float. For example, the supervisory system 120 may determine that minimum energy consumption by the homogeneous CDU group 112a may be achieved by leaving the unit activation threshold 144d at 75% of group cooling capacity.

Similarly, dynamic movement of a unit activation threshold 144 to the right may represent a later activation of an additional CDU 114b-114e (and associated ramping or deactivation of other active or inactive CDUs) by the local unit controller 118 at a higher proportion of group cooling capacity.

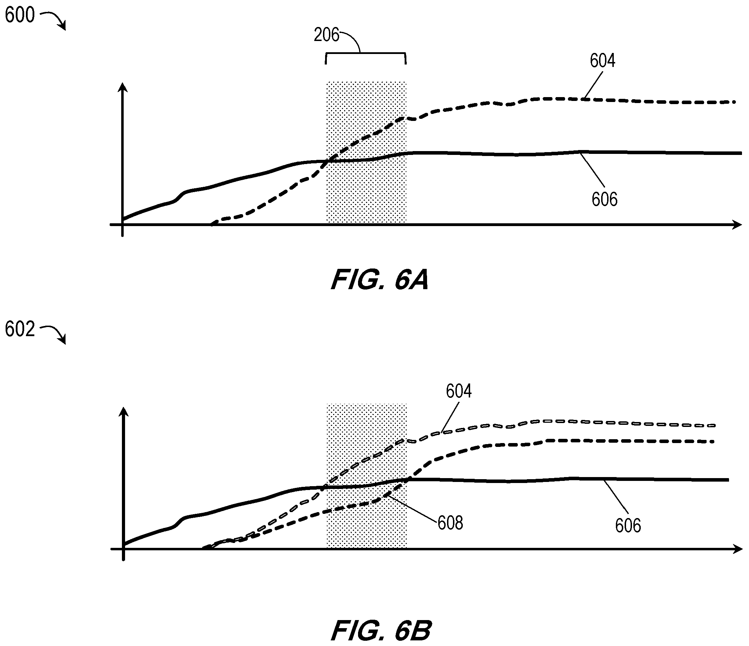

Referring now to FIGS. 6A and 6B, the graphs 600 and 602 respectively represent group cooling capacity and group energy consumption with respect to a system-level call for cooling 206 to the group 112 of CDUs 114.

In embodiments, referring in particular to FIG. 6A, adhering to the unit activation thresholds 144, 144d-144d provided for by the control profile 140 may result in a roughly linear increase in energy consumption 604 while maintaining the required cooling capacity 606 in response to the system-level call for cooling 206.

Referring also to FIG. 6B, however, by selecting optimal switching thresholds 504, 506 (see, e.g., FIG. 5B) via which one or unit activation thresholds 144b-144d may be adjusted within their respective threshold modification ranges 146, substantially the same group cooling capacity 606 may be maintained in response to the system-level call for cooling 206. However, as shown by the graph 602, the selection of optimal switching thresholds 504, 506 by the supervisory system 120 (and implementation of the optimal switching thresholds by the local unit controller 118) may result in a significantly lower level of energy consumption 608 while maintaining a consistent group cooling capacity 606.

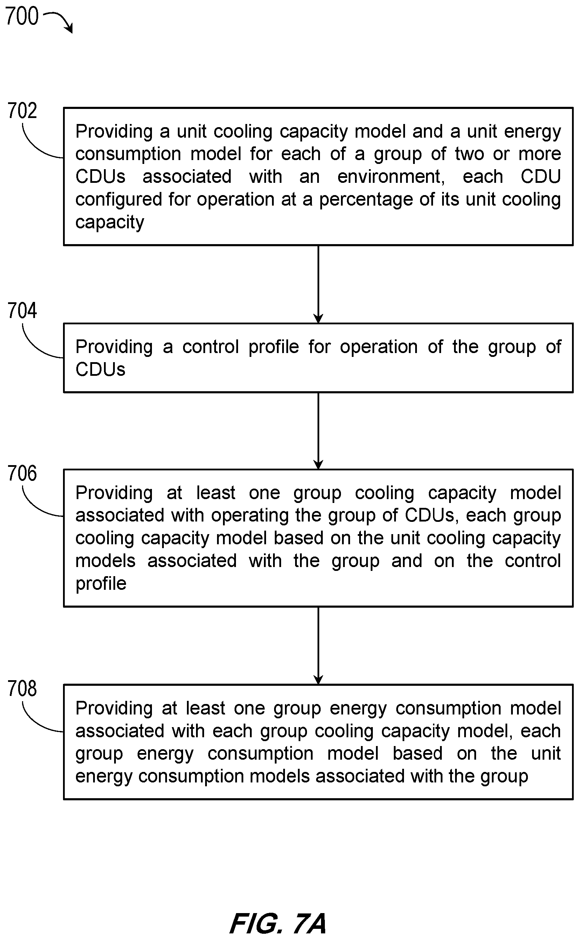

Referring now to FIG. 7A, the method 700 may be implemented by the supervisory system 120 and local unit controller 118 and may include the following steps.

At a step 702, the supervisory system is provided with mathematical models for unit performance (e.g., cooling capacity) and unit energy consumption for each of a group of cooling delivery units (CDU) deployed to a data center or like enclosed environment and configured for group operation to maintain the data center within a predetermined temperature range. For example, the mathematical models may include a priority order for activating CDUs within the group, even if the group is homogeneous (e.g., all CDUs operate according to a common or shared unit cooling capacity model and unit energy consumption model. If, however, the group is heterogeneous, e.g., includes more than one type of CDU, the priority order will specify which CDUs, or types of CDU, will be activated first.

At a step 704, the supervisory system is provided with a control profile for group operation of the CDU group by the local unit controller. In some embodiments, the control profile includes a group operating mode (e.g., reach-and-keep, parallel-ramp), fixed unit activation thresholds and unit ramping profiles for each CDU, and a threshold modification range allowing for deviations (e.g., in one or both directions) from one or more unit activation thresholds.

At a step 706, the supervisory system determines (e.g., and stores to memory) a group cooling capacity model for the CDU group based on each of a set of possible ambient temperatures (e.g., ambient air temperature (AAT)), the unit cooling capacity models of each CDU, and the group control profile. For example, the group cooling capacity model may be calculated as a function of airflow into the data center, as a function of ambient temperature, and as a function of unit activations. Further, from each possible ambient temperature may be derived temperature requirements based on that ambient temperature, e.g., a required supply air temperature (SAT) for chilled air entering the data center and a required return air temperature (RAT) of air leaving the data center (and carrying heat transferred from the data center).

At a step 708, the chiller optimization system determines (e.g., and stores to memory) a group energy consumption model for the CDU group based on the unit energy consumption model for each CDU of the group. As with the group cooling capacity model/s, the group energy consumption model/s may be calculated as a function of airflow into the data center, as a function of ambient temperature, and/or as a function of unit activations.

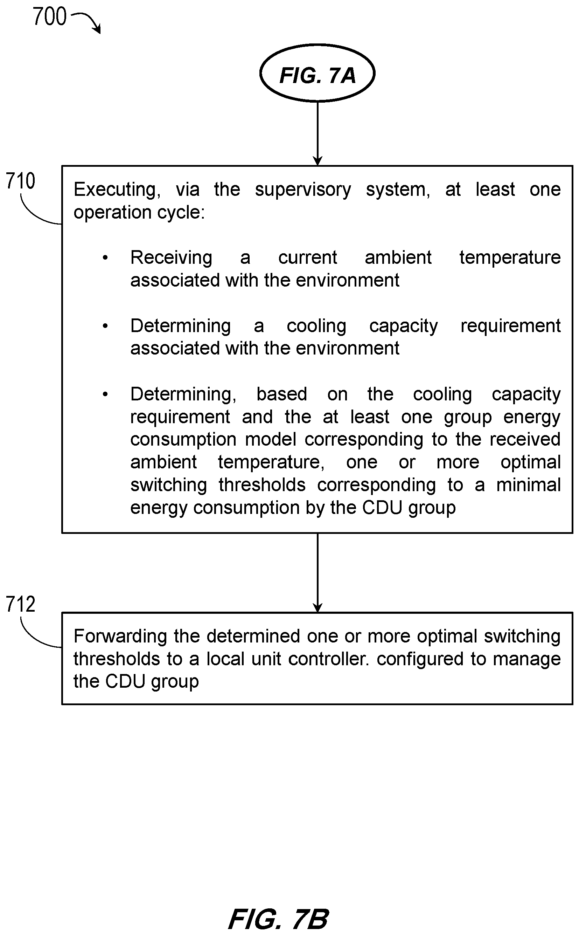

Referring also to FIG. 7B, at a step 710, the supervisory system executes one or more operation cycles on a dynamic basis (e.g., periodic cycles at predetermined time intervals, condition-driven or event-driven cycles) whereby optimal switching thresholds for the CDU group are determined such that the required cooling load may be maintained on an uninterrupted basis while consistently minimizing energy consumption by the CDUs as a group. For example, the supervisory system first determines a current ambient temperature (e.g., receives an AAT sensed outside, but proximate to, the data center). Further, the supervisory system determines a cooling capacity requirement (e.g., cooling load requirement). For example, the cooling capacity requirement may be based on return air temperature (RAT) and supply air temperature (SAT) requirements for maintaining the required temperature range, as well as actual remote (REM) temperatures sensed within the data center proximate to the servers). Further still, based on the cooling capacity requirement and the stored group cooling capacity models and group energy consumption models corresponding to the current AAT, the supervisory system determines a set of optimal switching thresholds (which may be equivalent to the fixed switching thresholds, or may deviate therefrom within the threshold modification ranges provided by the control profile) for maintaining the cooling capacity requirement while minimizing energy consumption by the CDUs as a group. For example, the set of group cooling capacity models may be filtered to eliminate any models not relevant to the current ambient temperature (e.g., and/or not relevant to the current airflow through the data center, or not matching the unit ramping profiles provided for by the control profile). Any remaining candidate group cooling capacity models are analyzed based on their corresponding group energy consumption models, in order to identify the group energy consumption model capable of maintaining the required cooling capacity under current conditions while consuming the minimum possible amount of energy.

The method 700 may include an additional step 712. At the step 712, the supervisory system forwards the set of optimal switching thresholds to the local area controller for implementation. For example, the local area controller may adjust one or more unit activation thresholds based on the received set of optimal switching thresholds, if doing so would result in reduced energy consumption compared to the current operating conditions of the group of CDUs.

### CONCLUSION

It is contemplated that embodiments of the inventive concepts disclosed herein may have numerous advantages. For example, as noted above, continual evaluation of optimal switching thresholds allows the cooling delivery system to maintain the data center within required temperature ranges while adjusting on a dynamic basis to maintain the minimum possible energy consumption by the group of cooling delivery units.

Those having skill in the art will recognize that the state of the art has progressed to the point where there is little distinction left between hardware and software implementations of aspects of systems; the use of hardware or software is generally (but not always, in that in certain contexts the choice between hardware and software can become significant) a design choice representing cost vs. efficiency tradeoffs. Those having skill in the art will appreciate that there are various vehicles by which processes and/or systems and/or other technologies described herein can be implemented (e.g., hardware, software, and/or firmware), and that the preferred vehicle will vary with the context in which the processes and/or systems and/or other technologies are deployed. For example, if an implementer determines that speed and accuracy are paramount, the implementer may opt for a mainly hardware and/or firmware vehicle; alternatively, if flexibility is paramount, the implementer may opt for a mainly software implementation; or, yet again alternatively, the implementer may opt for some combination of hardware, software, and/or firmware. Hence, there are several possible vehicles by which the processes and/or devices and/or other technologies described herein may be implemented, none of which is inherently superior to the other in that any vehicle to be utilized is a choice dependent upon the context in which the vehicle will be deployed and the specific concerns (e.g., speed, flexibility, or predictability) of the implementer, any of which may vary. Those skilled in the art will recognize that optical aspects of implementations will typically employ optically-oriented hardware, software, and or firmware.

The foregoing detailed description has set forth various embodiments of the devices and/or processes via the use of block diagrams, flowcharts, and/or examples. Insofar as such block diagrams, flowcharts, and/or examples contain one or more functions and/or operations, it will be understood by those within the art that each function and/or operation within such block diagrams, flowcharts, or examples can be implemented, individually and/or collectively, by a wide range of hardware, software, firmware, or virtually any combination thereof. In one embodiment, several portions of the subject matter described herein may be implemented via Application Specific Integrated Circuits (ASICs), Field Programmable Gate Arrays (FPGAs), digital signal processors (DSPs), or other integrated formats. However, those skilled in the art will recognize that some aspects of the embodiments disclosed herein, in whole or in part, can be equivalently implemented in integrated circuits, as one or more computer programs running on one or more computers (e.g., as one or more programs running on one or more computer systems), as one or more programs running on one or more processors (e.g., as one or more programs running on one or more microprocessors), as firmware, or as virtually any combination thereof, and that designing the circuitry and/or writing the code for the software and/or firmware would be well within the skill of one of skill in the art in light of this disclosure. In addition, those skilled in the art will appreciate that the mechanisms of the subject matter described herein are capable of being distributed as a program product in a variety of forms, and that an illustrative embodiment of the subject matter described herein applies regardless of the particular type of signal bearing medium used to actually carry out the distribution. Examples of a signal bearing medium include, but are not limited to, the following: a recordable type medium such as a floppy disk, a hard disk drive, a Compact Disc (CD), a Digital Video Disk (DVD), a digital tape, a computer memory, etc.; and a transmission type medium such as a digital and/or an analog communication medium (e.g., a fiber optic cable, a waveguide, a wired communications link, a wireless communication link, etc.).

In a general sense, those skilled in the art will recognize that the various aspects described herein which can be implemented, individually and/or collectively, by a wide range of hardware, software, firmware, or any combination thereof can be viewed as being composed of various types of "electrical circuitry." Consequently, as used herein "electrical circuitry" includes, but is not limited to, electrical circuitry having at least one discrete electrical circuit, electrical circuitry having at least one integrated circuit, electrical circuitry having at least one application specific integrated circuit, electrical circuitry forming a general purpose computing device configured by a computer program (e.g., a general purpose computer configured by a computer program which at least partially carries out processes and/or devices described herein, or a microprocessor configured by a computer program which at least partially carries out processes and/or devices described herein), electrical circuitry forming a memory device (e.g., forms of random access memory), and/or electrical circuitry forming a communications device (e.g., a modem, communications switch, or optical-electrical equipment). Those having skill in the art will recognize that the subject matter described herein may be implemented in an analog or digital fashion or some combination thereof.

Those having skill in the art will recognize that it is common within the art to describe devices and/or processes in the fashion set forth herein, and thereafter use engineering practices to integrate such described devices and/or processes into data processing systems. That is, at least a portion of the devices and/or processes described herein can be integrated into a data processing system via a reasonable amount of experimentation. Those having skill in the art will recognize that a typical data processing system generally includes one or more of a system unit housing, a video display device, a memory such as volatile and non-volatile memory, processors such as microprocessors and digital signal processors, computational entities such as operating systems, drivers, graphical user interfaces, and applications programs, one or more interaction devices, such as a touch pad or screen, and/or control systems including feedback loops and control motors (e.g., feedback for sensing position and/or velocity; control motors for moving and/or adjusting components and/or quantities). A typical data processing system may be implemented utilizing any suitable commercially available components, such as those typically found in data computing/communication and/or network computing/communication systems.

The herein described subject matter sometimes illustrates different components contained within, or connected with, different other components. It is to be understood that such depicted architectures are merely exemplary, and that in fact many other architectures can be implemented which achieve the same functionality. In a conceptual sense, any arrangement of components to achieve the same functionality is effectively "associated" such that the desired functionality is achieved. Hence, any two components herein combined to achieve a particular functionality can be seen as "associated with" each other such that the desired functionality is achieved, irrespective of architectures or intermedial components. Likewise, any two components so associated can also be viewed as being "operably connected", or "operably coupled", to each other to achieve the desired functionality, and any two components capable of being so associated can also be viewed as being "operably couplable", to each other to achieve the desired functionality. Specific examples of operably couplable include but are not limited to physically mateable and/or physically interacting components and/or wirelessly interactable and/or wirelessly interacting components and/or logically interacting and/or logically interactable components.

While particular aspects of the present subject matter described herein have been shown and described, it will be apparent to those skilled in the art that, based upon the teachings herein, changes and modifications may be made without departing from the subject matter described herein and its broader aspects and, therefore, the appended claims are to encompass within their scope all such changes and modifications as are within the true spirit and scope of the subject matter described herein. Furthermore, it is to be understood that the invention is defined by the appended claims.

The disclosure comprises the following items:
1. A thermal management system for dynamic unit staging, the system comprising:
   a group of two or more cooling delivery units configured for cooling an environment;
   a local unit controller configured to manage the group of cooling delivery units;
   a supervisory system comprising:
      a memory configured for storage of:
         at least one group cooling capacity model associated with the group of cooling delivery units, each group cooling capacity model based on a unit cooling capacity model for each cooling delivery unit and at least one control profile for unit staging of the group of cooling delivery units; and
         at least one group energy consumption model corresponding to each group cooling capacity model, each group energy consumption model including a unit energy consumption model corresponding to each cooling delivery unit; and
      an optimization processor coupled to the memory, the optimization processor configured to execute at least one operation cycle comprising:
         receiving a current ambient temperature external to the environment;
         determining a cooling capacity requirement associated with the environment; and
         determining, based on the cooling capacity requirement and the at least one group energy consumption model corresponding to the received ambient temperature, one or more optimal switching thresholds corresponding to a minimal energy consumption by the group of cooling delivery units.
2. The system of item 1, wherein each control profile includes:
   at least one unit activation threshold associated with a cooling delivery unit of the group; and
   a threshold modification range associated with each unit activation threshold;
   wherein each optimal switching threshold is within a threshold modification range of an associated cooling delivery unit of the group;
      and
   wherein each optimal switching threshold is associated with at least one of an activation of the associated cooling delivery unit, a deactivation of the associated cooling delivery unit, or a ramping of the associated cooling delivery unit.
3. The system of item 1 or item 2, wherein the group of cooling delivery units is a homogeneous group of cooling delivery units of a common type, each cooling delivery unit sharing a unit cooling capacity model and a unit energy consumption model.
4. The system of any preceding item, wherein:
   the group of cooling delivery cooling delivery units is a heterogeneous group of cooling delivery units of N types;
   wherein N is an integer not less than two;
   wherein each Nth type cooling delivery unit is associated with an Nth unit cooling capacity model and an Nth unit energy consumption model;
      and
   wherein the control profile includes an ordered list of the group of cooling delivery units ranked in order of activation by type.
5. The system of any preceding item, wherein the at least one group cooling capacity model is a function of a subset of active cooling delivery units selected from the group of cooling delivery units.
6. The system of any preceding item, wherein each group cooling capacity model corresponds to a possible ambient temperature.
7. The system of any preceding item, wherein determining at least one cooling capacity requirement associated with the environment includes:
   determining, based on the received ambient temperature, a required return air temperature (RAT) and a required supply air temperature (SAT) associated with the environment; and
   determining a cooling capacity requirement based on the required RAT and the required SAT.
8. The system of any preceding item, wherein each control profile includes a group operating mode is selected from a group including a reach-and-keep mode and a parallel mode.
9. The system of any preceding item, further comprising:
   a local unit controller configured to manage the group of cooling delivery units;
      and
   wherein the optimization processor is configured to forward the one or more optimal switching thresholds to the local unit controller.
10. The system of any preceding item, wherein the optimization processor is configured to periodically execute the at least one operation cycle based on at least one of a predetermined time interval or one or more trigger conditions.
11. A method for dynamic unit staging of a thermal management system, the method comprising:
   providing a unit cooling capacity model and a unit energy consumption model for each of a group of two or more cooling delivery units associated with an environment;
   providing a control profile for operation of the group of cooling delivery units,
   providing at least one group cooling capacity model associated with operating the group of cooling delivery units, each group cooling capacity model based on the unit cooling capacity models associated with the group and on the control profile;
   providing at least one group energy consumption model associated with each group cooling capacity model, each group energy consumption model based on the unit energy consumption models associated with the group; and
   executing, via a supervisory system including an optimization processor, at least one operation cycle comprising:
      receiving a current ambient temperature external to the environment;
      determining a cooling capacity requirement associated with the environment; and
      determining, based on the cooling capacity requirement and the at least one group energy consumption model corresponding to the received ambient temperature, one or more optimal switching thresholds corresponding to a minimal energy consumption by the group of cooling delivery units.
12. The method of item 11, wherein:
   each control profile includes:
      at least one unit activation threshold associated with a cooling delivery unit of the group; and
      a threshold modification range associated with each unit activation threshold;
   wherein each optimal switching threshold is within the threshold activation range of the corresponding cooling delivery unit of the group, and
   wherein each optimal switching threshold is associated with at least one of an activation of the associated cooling delivery unit, a deactivation of the associated cooling delivery unit, or a ramping of the associated cooling delivery unit.
13. The method of item 11 or item 12, wherein providing a unit cooling capacity model for each of a group of cooling delivery units associated with an environment includes:
   providing, for each of a homogeneous group of cooling delivery units of a common type, a shared unit cooling capacity model and an ordered list ranking the group of cooling delivery units in order of activation.
14. The method of any of items 11-13, wherein providing a unit cooling capacity model for each of a group of cooling delivery units associated with an environment includes:
   providing for each type of a heterogeneous group of cooling delivery units of N types, where N is an integer not less than two, an Nth unit cooling capacity model corresponding to each cooling delivery unit of the Nth type.
15. The method of any of items 11-14, wherein the control profile includes an ordered list of the group of cooling delivery units in order of activation by type.
16. The method of any of items 11-15, wherein providing at least one group cooling capacity model associated with operating the group of cooling delivery units includes:
   providing at least one group cooling capacity model associated with the group of cooling delivery units, wherein the at least one group cooling capacity is a function of a subset of active cooling delivery units selected from the group of cooling delivery units.
17. The method of any of items 11-16, wherein providing at least one group cooling capacity model associated with operating the group of cooling delivery units includes:
   providing at least one group cooling capacity model associated with operating the group of cooling delivery units, wherein each group cooling capacity model corresponds to a possible ambient temperature.
18. The method of any of items 11-17, wherein determining, based on the received ambient temperature, a cooling load capacity requirement associated with the environment includes:
   determining, based on the received ambient temperature, a required return air temperature (RAT) and a required supply air temperature (SAT); and
   determining a cooling capacity requirement based on the required RAT and the required SAT.
19. The method of any of items 11-18, further comprising:
   forwarding the determined one or more optimal switching thresholds to a local unit controller configured to manage the group of cooling delivery units.
20. The method of any of items 11-19, wherein executing at least one operation cycle includes at least one of:
   executing at least one operation cycle based on a predetermined time interval;
   or
   executing at least one operation cycle in response to one or more triggering conditions.

A1. A system for optimized dynamic unit staging of a thermal management system, the method comprising:
   a) a plurality of chiller units,
      each chiller unit configured to deliver chilled air into a climate-controlled environment and to receive return air corresponding to a return air temperature (RAT),
   b) a cooling system controller configured to manage the plurality of cooling units via one or more commands, each command directing at least one chiller unit of the plurality to:
      assume an inactive or standby state;
      or
      operate at a percentage P of its cooling capacity, wherein P is a number more than zero and not more than 100;
   c) a memory configured for storage of:
      at least one unit cooling capacity model associated with a chiller unit of the plurality of chiller units;
      at least one unit energy consumption model associated with a chiller unit of the plurality of chiller units;
      a control profile for unit staging of the plurality of chiller units, the control profile comprising:
         a group operating mode for the plurality of chiller units;
         a threshold for activation of each chiller unit;
         a unit ramping profile corresponding to each chiller unit;
            and
         a threshold modification level associated with each threshold;
            and
         a plurality of RAT and supply air temperature (SAT) requirements associated with the climate-controlled environment;
            and
   d) at least one optimization processor communicatively coupled to the memory, the at least one optimization processor configured to:
      determine, based on the at least one unit cooling capacity model, the at least one unit energy consumption model, and the control profile:
      at least one group cooling capacity parameter of the plurality of chiller units, each group cooling capacity parameter associated with a RAT and a SAT requirement;
         and
      at least one group energy consumption parameter of the plurality of chiller units, each group energy consumption corresponding to a group cooling capacity parameter;
         and
      execute at least one operation cycle comprising:
         receiving a current ambient air temperature (AAT);
         determine a cooling capacity requirement based on the received AAT;
            and
         determine, based on the cooling capacity requirement, the at least one group cooling capacity requirement corresponding to the received AAT, and the at least one group energy consumption parameter corresponding to the received AAT:
            a set of switching thresholds within the at least one threshold modification level, each switching threshold associated with at least one of 1) an activation of an inactive chiller unit, 2) a deactivation of an active chiller unit, or 3) an adjustment of the percentage P associated with at least one active chiller unit, the determined set of switching thresholds associated with a minimal energy consumption of the plurality of chiller units.
A2. The system of item A1, wherein the plurality of chiller units is a set of identical chiller units, each chiller unit sharing a unit cooling capacity model and a unit energy consumption model.
A3. The system of item A1 or item A2, wherein the plurality of chiller units is a set of non-homogeneous chiller units of N types, wherein N is an integer not less than two, and wherein each Nth type chiller unit is associated with an Nth cooling capacity model and an Nth energy consumption model;
   and
   wherein the control profile includes an ordered list of the plurality of chiller units ranked in activation order.
A4. The system of any of items A1-A3, wherein the at least one group cooling capacity is a function of one or more of:
   a subset of active chiller units selected from the plurality of chiller units;
   or
   a subset of active chiller units selected from the ordered list of chiller units.
A5. The system of any of items A1-A4, wherein the at least one group cooling capacity is a function of an AAT.
A6. The system of any of items A1-A5, wherein the at least one group cooling capacity is a function of total airflow into the climate-controlled environment.
A7. The system of any of items A1-A6, wherein the group operating mode is selected from a group including a reach-and-keep mode and a parallel mode.
A8. The system of any of items A1-A7, wherein the at least one optimization processor is configured to forward the determined set of switching thresholds to the cooling system controller.
A9. The system of any of items A1-A8, wherein the at least one optimization processor is configured to periodically execute the operation cycle based on a predetermined time interval.
A10. The system of any of items A1-A9, wherein the at least one optimization processor is configured to periodically execute the operation cycle in response to one or more trigger conditions.
A11. A method for optimized dynamic unit staging of a thermal management system, the method comprising:
   providing, for each of a plurality of chiller units associated with a climate-controlled environment, a unit cooling capacity model and a unit energy consumption model;
   providing a control profile for operating the plurality of chiller units, the control profile comprising:
      a group operating mode;
      an activation threshold associated with each chiller unit;
      a unit ramping profile associated with each chiller unit;
         and
      a threshold modification range associated with each activation threshold;
      providing a plurality of supply air temperature (SAT) requirements, each SAT requirement associated with a return air temperature (RAT) of the climate-controlled environment;
      determining, based on the unit cooling capacity models and the control profile, at least one group cooling capacity model associated with the plurality of chiller units, each group cooling capacity corresponding to an ambient air temperature (AAT);
      determining, for each determined group cooling capacity model, at least one group energy consumption model of the plurality of chiller units based on the unit energy consumption models;
      storing to memory the at least one group cooling capacity model and the at least one group energy consumption model;
         and
      executing at least one operation cycle comprising:
         receiving a current AAT associated with the climate-controlled environment;
         determining, based on the received AAT and the at least one group cooling capacity model, a cooling load requirement associated with the climate-controlled environment; and
         determining, based on the cooling capacity requirement, the at least one group cooling capacity requirement corresponding to the received AAT, and the at least one group energy consumption parameter corresponding to the received AAT, a set of switching thresholds within the at least one threshold modification range, each switching threshold associated with at least one of 1) an activation of a chiller unit, 2) a deactivation of a chiller unit, or 3) an adjustment of the percentage P associated with a chiller unit, the set of switching thresholds configured to achieve the cooling load requirement and corresponding to a minimal group energy consumption model.
A12. The method of item A11, wherein providing, for each of a plurality of chiller units associated with a climate-controlled environment, a unit cooling capacity model and a unit energy consumption model includes:
   providing for each of a plurality of homogeneous chiller units:
   a shared unit cooling capacity model;
   a shared unit energy consumption model;
      and
   an ordered list ranking the plurality of chiller units in order of activation.
A13. The method of item A11 or item A12, wherein providing, for each of a plurality of chiller units associated with a climate-controlled environment, a unit cooling capacity model and a unit energy consumption model includes:
   providing for each of a plurality of non-homogeneous chiller units of N types, where N is an integer not less than two:
   an Nth unit cooling capacity model and an Nth unit energy consumption model corresponding to each chiller unit of an Nth type.
A14. The method of any of items A11-A13, wherein the plurality of chiller units is a set of non-homogeneous chiller units of N types, wherein N is an integer not less than two, and wherein each Nth type chiller unit is associated with an Nth cooling capacity model and an Nth energy consumption model;
   and
   wherein the control profile includes an ordered list of the plurality of chiller units ranked in activation order.
A15. The method of any of items A11-A14, wherein determining, based on the unit cooling capacity models and the control profile, at least one group cooling capacity model associated with the plurality of chiller units includes:
   determining at least one group cooling capacity model associated with the plurality of chiller units, wherein the at least one group cooling capacity is a function of one or more of:
   a subset of active chiller units selected from the plurality of chiller units;
   or
   a subset of active chiller units selected from the ordered list of chiller units.
A16. The method of any of items A11-A15, wherein determining, based on the unit cooling capacity models and the control profile, at least one group cooling capacity model associated with the plurality of chiller units includes:
   determining at least one group cooling capacity model associated with the plurality of chiller units, wherein the at least one group cooling capacity is a function of an AAT.
A17. The method of any of items A11-A16, wherein determining, based on the unit cooling capacity models and the control profile, at least one group cooling capacity model associated with the plurality of chiller units includes:
   determining at least one group cooling capacity model associated with the plurality of chiller units, wherein the at least one group cooling capacity is a function of total airflow into the climate-controlled environment.
A18. The method of any of items A11-A17, further comprising:
   forwarding the determined set of switching thresholds to the cooling system controller.
A19. The method of any of items A11-A18, wherein executing at least one operation cycle includes:
   executing at least one operation cycle based on a predetermined time interval.
A20. The method of any of items A11-A19, wherein executing at least one operation cycle includes:
   executing at least one operation cycle in response to one or more triggering conditions.

## Claims

1. A thermal management system for dynamic unit staging, the system comprising:
a group of two or more cooling delivery units configured for cooling an environment;
a local unit controller configured to manage the group of cooling delivery units;
a supervisory system comprising:
a memory configured for storage of:
at least one group cooling capacity model associated with the group of cooling delivery units, each group cooling capacity model based on a unit cooling capacity model for each cooling delivery unit and at least one control profile for unit staging of the group of cooling delivery units; and
at least one group energy consumption model corresponding to each group cooling capacity model, each group energy consumption model including a unit energy consumption model corresponding to each cooling delivery unit; and
an optimization processor coupled to the memory, the optimization processor configured to execute at least one operation cycle comprising:
receiving a current ambient temperature external to the environment;
determining a cooling capacity requirement associated with the environment; and
determining, based on the cooling capacity requirement and the at least one group energy consumption model corresponding to the received ambient temperature, one or more optimal switching thresholds corresponding to a minimal energy consumption by the group of cooling delivery units.

2. The system of Claim 1, wherein each control profile includes:
at least one unit activation threshold associated with a cooling delivery unit of the group; and
a threshold modification range associated with each unit activation threshold;
wherein each optimal switching threshold is within a threshold modification range of an associated cooling delivery unit of the group;
and
wherein each optimal switching threshold is associated with at least one of an activation of the associated cooling delivery unit, a deactivation of the associated cooling delivery unit, or a ramping of the associated cooling delivery unit.

3. The system of Claim 1 or Claim 2, wherein the group of cooling delivery units is a homogeneous group of cooling delivery units of a common type, each cooling delivery unit sharing a unit cooling capacity model and a unit energy consumption model.

4. The system of Claim 1 or Claim 2, wherein:
the group of cooling delivery cooling delivery units is a heterogeneous group of cooling delivery units of N types;
wherein N is an integer not less than two;
wherein each Nth type cooling delivery unit is associated with an Nth unit cooling capacity model and an Nth unit energy consumption model;
and
wherein the control profile includes an ordered list of the group of cooling delivery units ranked in order of activation by type.

5. The system of any preceding Claim, wherein the at least one group cooling capacity model is a function of a subset of active cooling delivery units selected from the group of cooling delivery units, and/or wherein each group cooling capacity model corresponds to a possible ambient temperature.

6. The system of any preceding Claim, wherein determining at least one cooling capacity requirement associated with the environment includes:
determining, based on the received ambient temperature, a required return air temperature, RAT, and a required supply air temperature, SAT, associated with the environment; and
determining a cooling capacity requirement based on the required RAT and the required SAT.

7. The system of any preceding Claim, wherein each control profile includes a group operating mode is selected from a group including a reach-and-keep mode and a parallel mode.

8. The system of any preceding Claim, further comprising:
a local unit controller configured to manage the group of cooling delivery units;
and
wherein the optimization processor is configured to forward the one or more optimal switching thresholds to the local unit controller.

9. The system of any preceding Claim, wherein the optimization processor is configured to periodically execute the at least one operation cycle based on at least one of a predetermined time interval or one or more trigger conditions.

10. A method for dynamic unit staging of a thermal management system, the method comprising:
providing a unit cooling capacity model and a unit energy consumption model for each of a group of two or more cooling delivery units associated with an environment;
providing a control profile for operation of the group of cooling delivery units,
providing at least one group cooling capacity model associated with operating the group of cooling delivery units, each group cooling capacity model based on the unit cooling capacity models associated with the group and on the control profile;
providing at least one group energy consumption model associated with each group cooling capacity model, each group energy consumption model based on the unit energy consumption models associated with the group; and
executing, via a supervisory system including an optimization processor, at least one operation cycle comprising:
receiving a current ambient temperature external to the environment;
determining a cooling capacity requirement associated with the environment; and
determining, based on the cooling capacity requirement and the at least one group energy consumption model corresponding to the received ambient temperature, one or more optimal switching thresholds corresponding to a minimal energy consumption by the group of cooling delivery units.

11. The method of Claim 10, wherein:
each control profile includes:
at least one unit activation threshold associated with a cooling delivery unit of the group; and
a threshold modification range associated with each unit activation threshold;
wherein each optimal switching threshold is within the threshold activation range of the corresponding cooling delivery unit of the group, and
wherein each optimal switching threshold is associated with at least one of an activation of the associated cooling delivery unit, a deactivation of the associated cooling delivery unit, or a ramping of the associated cooling delivery unit.

12. The method of Claim 10 or claim 11, wherein providing a unit cooling capacity model for each of a group of cooling delivery units associated with an environment includes:
providing, for each of a homogeneous group of cooling delivery units of a common type, a shared unit cooling capacity model and an ordered list ranking the group of cooling delivery units in order of activation; or
providing for each type of a heterogeneous group of cooling delivery units of N types, where N is an integer not less than two, an Nth unit cooling capacity model corresponding to each cooling delivery unit of the Nth type, and optionally wherein the control profile includes an ordered list of the group of cooling delivery units in order of activation by type.

13. The method of any of Claims 10-12, wherein providing at least one group cooling capacity model associated with operating the group of cooling delivery units includes:
providing at least one group cooling capacity model associated with the group of cooling delivery units, wherein the at least one group cooling capacity is a function of a subset of active cooling delivery units selected from the group of cooling delivery units; and/or
providing at least one group cooling capacity model associated with operating the group of cooling delivery units, wherein each group cooling capacity model corresponds to a possible ambient temperature.

14. The method of any of Claims 10-13, wherein determining, based on the received ambient temperature, a cooling load capacity requirement associated with the environment includes:
determining, based on the received ambient temperature, a required return air temperature, RAT, and a required supply air temperature, SAT,; and
determining a cooling capacity requirement based on the required RAT and the required SAT.

15. The method of any of Claims 10-14, wherein:
the method further comprises forwarding the determined one or more optimal switching thresholds to a local unit controller configured to manage the group of cooling delivery units; and/or
executing at least one operation cycle includes at least one of:
executing at least one operation cycle based on a predetermined time interval;
or
executing at least one operation cycle in response to one or more triggering conditions.
